# EUROPEAN PATENT APPLICATION

(11) **EP 4 726 404 A1**
(43) Date of publication of application: **15.04.2026**
(21) Application number: 25206483.7
(22) Date of filing: 02.10.2025
(51) Int. Cl.: G01R 31/34

(54) **TEST RIG**

(30) Priority: 09.10.2024 GB 202414813
(71) Applicant: Currys Group Limited, London W3 6RS (GB)
(72) Inventor: JAMES, Christopher, Nottingham, NG23 6NU (GB); MOHANKUMAR, Vasanthakumar, Nottingham, NG24 3RU (GB)
(74) Representative: Cleveland Scott York

(57) **Abstract**

A test rig for detecting a fault in an electric motor comprising: a power supply means for supplying electrical power to the electric motor; and a processing means configured to: cause the power supply means to supply the electric motor with an operational voltage; operate the electric motor; receive operational data of the electric motor that is captured by a data capture means; determine an operational signature of the electric motor from the operational data, wherein the operational signature comprises an indication of a fault with the electric motor; and provide an indication of the fault to a user based on the determined operational signature.

## Description

This invention relates to a test rig for detecting a fault in an electric motor and a method of detecting a mechanical fault in an electric motor of an appliance.

### Background of the Invention

Universal motors are commonly used in various electrical appliances that operate principally via rotational action. Examples of such appliances are washing machines, drills, fans, blenders etc. Over time, due to use, the various components of the universal motor (such as segments of the commutator, field/rotor windings, contact brushes etc) can become damaged and/or faulty. These damaged components can lead to electrical sparking, which is hazardous to users of the appliance and presents a fire risk hazard. It is difficult to visually ascertain whether these components are damaged/faulty before a hazard occurs.

When electrical appliances become faulty due to a fault with the motor, conventional diagnostic methods test the electrical appliance as a whole, which can be time consuming, as various additional components of the electrical appliance other than the motor are also tested. For new electrical appliances, due to the lengthy diagnostic method, not all electrical appliances may be tested. Instead, appliances may be selected at random for testing, meaning not all of the universal motors of each appliance are tested. Consequently, faulty universal motors may be missed, which is costly to repair after the fact.

Further, for larger appliances such as washing machines, testing is typically carried out using relatively large (mains) voltages, which can be dangerous. In the UK, mains voltages are typically 230 volts.

The present invention aims to overcome or at least ameliorate one or more of the problems set out above.

### Summary of the Invention

In a first aspect of the invention, there is provided a test rig for detecting a fault in an electric motor comprising: a power supply means for supplying electrical power to the electric motor; and a processing means configured to: cause the power supply means to supply the electric motor with an operational voltage; operate the electric motor; receive operational data of the electric motor that is captured by a data capture means; determine an operational signature of the electric motor from the operational data, wherein the operational signature comprises an indication of a fault with the electric motor; and provide an indication of the fault to a user based on the determined operational signature.

In this way, an indication of a fault with the motor can be easily determined and indicated to the user. This removes the need for a user to have specialised training (which is time consuming and expensive) for interpreting raw operational data of the motor.

Preferably, the operational voltage is less than a mains voltage. This provides a safer testing environment using lower operating voltages, reduced current and torque of the motor (relative to testing the motor in the electrical appliance, which is typically supplied with main operational voltage).

Preferably, the operational data corresponds to a rotational speed of a rotor of the electric motor. In a preferably arrangement, the data capture means is a tachometer of the electric motor.

Preferably, the indication of a fault in the electric motor is a visual indication to the user. This is advantageous because it also removes the need for a user to have specialised training (which is time consuming and expensive) for interpreting raw operational data of the motor. The visual indication may provide a simple, effective means for the user to determine a fault. This may supplement indication of a fault that has no visual indication to give greater confidence there is indeed a fault.

In some arrangements, the visual indication comprises a visual plot of the operational signature of the electric motor. Additionally or alternatively, in some arrangements, the visual indication comprises a human readable notification (e.g., a 'Pass' or 'Fail' notification etc).

In one arrangement, the indicated fault is a fault with a motor brush and/or commutator segments of the electric motor. The operational signature may comprise an indication of voltage spikes of the motor thereby indicating a fault with a motor brush and/or commutator segments of the electric motor. The visual plot of the operational signature may visually accentuate the voltage spikes thereby visually indicating a fault to the user. Again, this may provide a simple, effective means for the user to determine a fault. This may supplement indication of a fault that has no visual indication to give greater confidence there is indeed a fault.

In another arrangement, the test rig may also comprise a temperature dependent resistor that is coupled to the power supply means, and the indicated fault is a fault with a bearing of the electric motor.

Preferably, the temperature dependent resistor is a thermistor.

The operational signature may comprise an indication of variance in rotational speed of the motor for a particular frequency of rotation thereby indicating a fault with a bearing of the electric motor. This corresponds to 'ripples' in the waveform represented by the operational signature. In this arrangement, the visual plot of the operational signature may visually accentuate the variance in rotational speed of the motor for a particular frequency of rotation thereby visually indicating a fault.

Preferably, the operational voltage is between 6 and 59 volts.

In a second aspect of the invention, there is provided a test rig as claimed and an electric motor, wherein the test rig is arranged to detect a fault in the electric motor.

Preferably, the electric motor has been isolated from an electrical appliance. This provides a safer testing environment using lower operating voltages, reduced current and torque of the motor (relative to testing the motor in the electrical appliance, which is typically supplied with main operational voltage).

In a third aspect of the invention, there is provided a method of detecting a fault in an electric motor, the method comprising the steps of: supplying the electric motor with an operational voltage; operating the electric motor; receiving operational data of the electric motor that is captured by a data capture means; determining an operational signature of the electric motor from the operational data, wherein the operational signature comprises an indication of a fault with the electric motor; and providing an indication of the fault to a user based on the determined operational signature.

Preferably, the electric motor is first disconnected from an electrical appliance; and the operational voltage is less than a mains voltage. This provides a safer testing environment using lower operating voltages, reduced current and torque of the motor (relative to testing the motor in the electrical appliance, which is typically supplied with main operational voltage).

Preferably, determining the operational signature comprises determining at least one of: the rising edges and the falling edges of the wave form represented by the operational data of the electric motor.

Preferably, providing an indication of the fault to a user based on the determined operational signature comprises: comparing a portion of data points of the determined operational signature with corresponding data points of a known operational signature of the electric motor and, if a difference between those data points is above a pre-determined threshold, notifying the user of a fault with the electric motor, otherwise, notifying the user of no fault with the electric motor. In this way, a fault with the motor can be determined, and the user notified, without plotting the operational signature.

In one arrangement, the operational signature comprises an indication of voltage spikes of the motor thereby indicating a fault with a motor brush and/or commutator segments of the electric motor; and providing an indication of the fault to a user based on the determined operational signature further comprises: determining a number of voltage spikes from the operational signature and, if the number is above a pre-defined threshold, notifying the user of a fault with the electric motor, otherwise, notifying the user of no fault with the electric motor.

In another arrangement, the operational signature comprises an indication of variance in rotational speed of the motor for a particular frequency of rotation thereby indicating a fault with a bearing of the electric motor; and providing an indication of the fault to a user based on the determined operational signature further comprises: determining a degree of variance in rotational speed of the motor for a particular frequency of rotation from the operational signature and, if the degree is above a pre-defined threshold, notifying the user of a fault with the electric motor, otherwise, notifying the user of no fault with the electric motor.

In yet other arrangements, the operational signature may comprise both an indication of voltage spikes of the motor and an indication of variance in rotational speed of the motor for a particular frequency of rotation thereby indicating a fault with a motor brush and/or commutator segments, and a fault with a bearing, of the electric motor.

### Brief Description of the Drawings

Embodiments of the invention will now be described by way of example, with reference to the drawings in which:-
Figure 1 illustrates a schematic block diagram of a test rig and motor;
Figure 2 is a flow chart illustrating a method for detecting a fault with a motor brush and/or commutator segments of an electric motor;
Figure 3 illustrates a representation of transient voltage spikes embedded within the sine wave output from the tachometer;
Figure 4a is a graph illustrating the visual output from the method of Figure 2 indicating a faulty motor brush and/or commutator segments of the electric motor - the Y-axis represents frequency, and the X-axis represents time;
Figure 4b is graph illustrating a non-faulty motor brush and/or commutator segments of the electric motor;
Figure 5 is a flow chart illustrating a method for detecting a fault with a bearing of the electric motor; and
Figure 6a is a graph illustrating the visual output from the method of Figure 5 indicating a faulty bearing of the electric motor - the Y-axis represents frequency, and the X-axis represents time; and
Figure 6b is graph illustrating a non-faulty bearing of the electric motor.

### Detailed Description

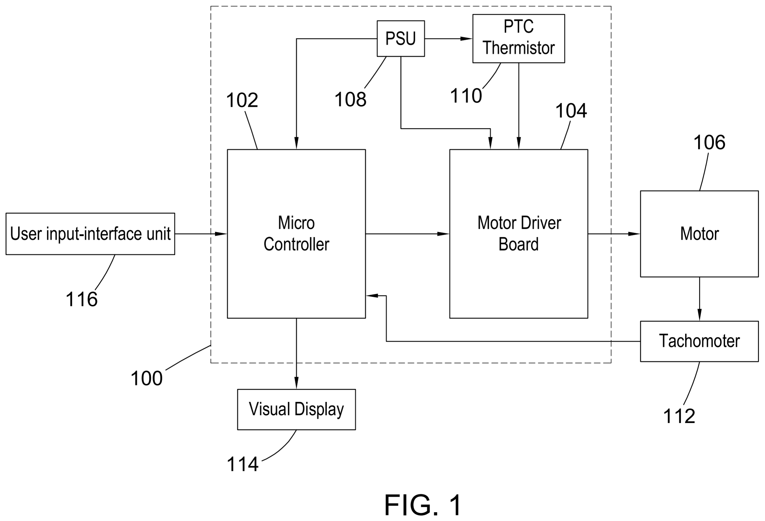

Figure 1 shows a test rig 100, the components of which are illustrated within the dashed lines. The test rig 100 comprises a micro-controller 102 comprising a processor (not shown) and a memory (not shown). The controller 102 is arranged for overall control of the test rig 100. In this embodiment, the controller 102 is connected to motor driver board 104. The motor driver unit 104 is arranged, via the controller 102, to drive an external motor 106 as desired (for example, to drive the motor clockwise, anti-clockwise and at a desired speed/frequency of rotation etc). In this embodiment, the driver unit 104 comprises a relay board. In other embodiments, a different switching means may be used to allow the motor to be suitably switched/actuated as desired.

The test rig 100 further comprises a power supply unit (PSU) 108. Power from the PSU 108 is used for powering the controller 102 and the driver unit 104. The test rig 100 is configured to connect to a mains power supply for supplying electrical power to the PSU 108. The PSU 108 is configured to convert the mains voltage to lower voltages for the controller 102 and, separately, for the driver unit 104. The PSU 108 is configured to operate the motor 106 (via the driver unit 104), with an operational voltage that is less than mains supply voltage (such as 230V). Preferably, the operational voltage is between 6 and 59V.

Operating the motor 106 at a voltage within this preferred range allows optimal benchmark testing of the motor 106 whilst minimising the risk to the user. This is because, at these voltages, voltage spikes and ripples (which are described further below) can still be detected whilst maintaining an operational voltage that is much less than a relatively high mains voltage (which is extremely dangerous to a user if the user is exposed to said voltage).

In this embodiment, the test rig 100 further comprises a thermistor 110, which is also powered by the PSU 108. The thermistor 110 will be described later on.

The test rig 100 is arranged to be connected to the electric motor 106 such that the test rig 100 (more specifically the driver unit 104) can drive the electric motor 106. As the test rig 100 drives the motor 106, the test rig 100 is configured to detect a fault in the electric motor 106. This is achieved by capturing operational data of the electric motor 106 and generating an operational signature of the electric motor 106 from the operational data. The operational signature that is generated comprises an indication of a fault in the electric motor 106.

In the present invention, the test rig 100 is arranged to detect a fault with a motor brush (not shown) and/or commutator segments (not shown) of the electric motor, and a fault with a bearing (not shown) of the motor 106. In some embodiments, the test rig 100 may be configured only to detect a fault with a motor brush (not shown) and/or commutator segments (not shown) of the electric motor. In other embodiments, the test rig 100 may be configured only to detect a fault with a bearing (not shown) of the motor 106. In embodiments configured to detect a fault with a motor brush and/or commutator segments only, the test rig 100 does not comprise the thermistor 110.

The method/process of the test rig 100 for detecting a fault with a motor brush (not shown) and/or commutator segments (not shown) of the electric motor will first be described.

In this embodiment, the electric motor 106 is a universal motor that comprises an tachometer 112. In this embodiment, the tachometer 112 is an electronic tachometer, but in other embodiments, the tachometer may be mechanical. The tachometer 112 is arranged to produce electrical pulses at a frequency proportional to the rotation speed of the motor 106. The controller 102 is arranged to receive output data from the tachometer 112 that indicates the rotational speed of the motor 106.

In this embodiment, the output data is a 'raw' sine wave obtained from the tachometer 112 (i.e., a plurality of data points having time and voltage amplitude components that (if graphically plotted) represent the 'raw' sine wave, which represents the rotation speed of the motor 106).

Within this output data is a degree of electrical noise (EMI). If the motor brush and/or commutator segments of the motor 106 are worn, damaged, raised or faulty, additional sparking of the motor 106 occurs during operation of the motor 106. These electrical sparks are detected by the tachometer 112 and present in the 'raw' sine wave (output data) obtained from the tachometer 112 as transient voltage spikes embedded with the detected/output sine wave. In other words, where a voltage spike occurs, the data point that is captured at that particular time period (or several data points within a relatively short time period) will have a much higher voltage amplitude relative to 'neighbouring' data points with 'normal' voltage amplitudes.

The method of the present invention is configured to generate an operational signature of the motor from the output data. The operational signature comprises an indication that there is a fault with the motor brush and/or commutator segments of the motor 106. This indication is based on the detected transient voltage spikes that were generated by the motor 106 due to the additional sparking.

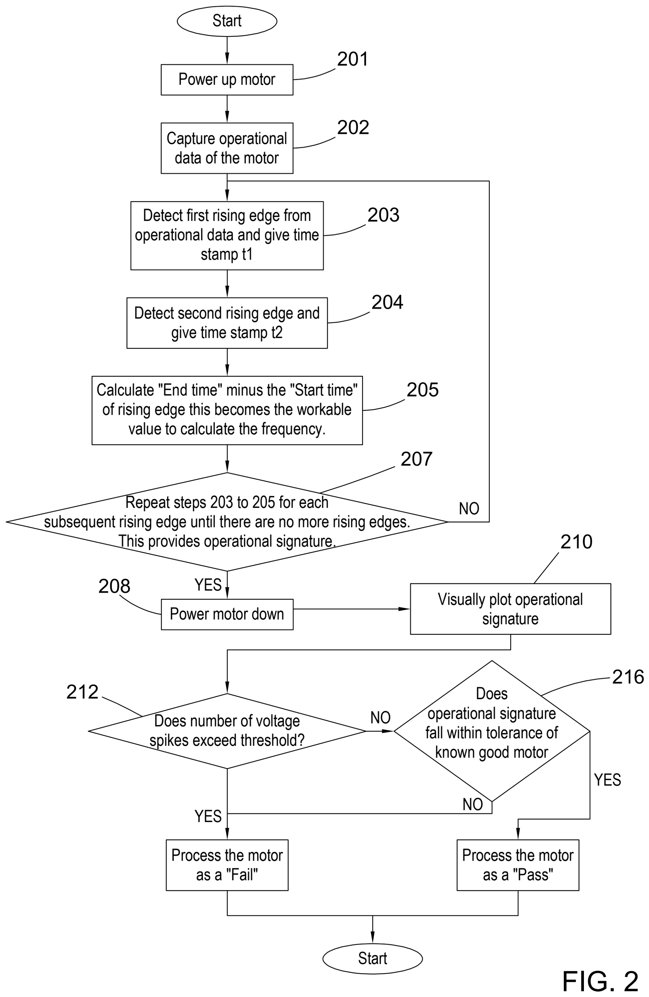

More specifically, in this embodiment, the method is configured to generate a visual representation of the output data that accentuates voltages spikes detected by the tachometer 112. These accentuations are a visual indication to a user there is a fault with the motor brush and/or commutator segments of the motor 106. The steps of this method will now be described in connection with Figure 2.

At step 201, the PSU 108 of the test rig 100 is arranged to supply the motor 106 (via driver board 104) with an operational voltage of between 6 and 59 volts, causing the motor 106 to rotate. In this embodiment, the controller 102 is arranged to cause the motor 106 to rotate at a pre-determined speed in a direction of rotation (i.e., clockwise and anti-clockwise) for a pre-determined time period. In other embodiments, the motor may be arranged to rotate at different speeds and directions of rotation for pre-determined time periods. In this way, motors with differing operational characteristics can be accommodated.

In this embodiment, the test rig 100 comprises a user interface 116 for allowing the user to control switching the motor on and off and/or determine what speed(s) and direction(s) to rotate the motor. The user interface may be an integral part of the test rig 100 or an external component (such as a keyboard of a computer) that is able to communicate with the controller 102 of the test rig 100. Preferably, the user pre-determines the different speeds and direction of rotation that will be carried out during testing of the motor.

At step 202, the tachometer 112 (i.e., a data capture means) is arranged to produce electrical pulses at a frequency proportional to the rotation speed of the motor 106. In other words, the tachometer 112 is arranged to capture operational data of the motor 106. This output data is provided to (or received by) the controller 102 of the test rig 100.

As described above, the output data comprises a plurality of data points having time and voltage amplitude components. At step 203, the controller 102 is arranged to determine a first rising edge from the operational data (i.e., captured sine wave data) at time t1. A rising edge in this context is when the sinusoidal waveform changes from a negative voltage to a positive (or 0) voltage (i.e., a change in voltage state from negative to not non-negative).

At step 204, a second rising edge of the sine waveform is determined at time t2. At step 205, a frequency of the sine wave is determined from the time between the first and second rising edge (i.e., a difference between t1 and t2). The result of this is then stored (i.e., in a memory of the controller 102).

At step 207, steps 203, 204 and 205 are repeated for all subsequent rising edges of the sine wave (and the results stored). So, a frequency of the sine wave is determined from the time between the second and third rising edge (i.e., a difference between t2 and t3), then for the time between the third rising and edge and the fourth rising edge, and so on. This occurs until the last rising edge of the sine wave has been determined/calculated/processed. The final stored data set represents an operational signature of the motor 106.

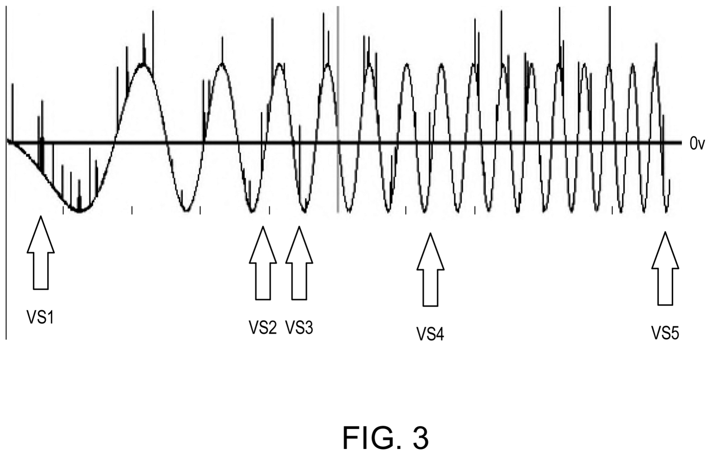

In addition to the 'normal' rising edges that are expected (i.e., generated from the tachometer in response to rotation of the motor), in this embodiment, rising edges in the sine wave caused by transient voltage spikes will also be determined/detected. Figure 3 illustrates a representation of transient voltage spikes embedded within the sine wave output from the tachometer. In the illustrated example sine wave, there are five transient voltage spikes (VS1-VS5) that result in rising edges. These rising edges would be detected/determined during steps 203, 204 and 205 (along with all of the other non-voltage spike related rising edges).

In other embodiments, in addition to (or instead of) determining rising edges, the voltage spikes that do not result in a rising edge may be determined/detected. For example, if a voltage of a data point is greater by a pre-determined threshold amount relative to the voltage of a preceding data point, this would indicate a voltage spike. In this way, more voltage spikes are able to be determined, which provides greater evidence/confidence of a fault. In arrangements requiring reduced complexity/cost however, determining voltage spikes only via rising edges is preferrable.

Thus, the controller 102 is arranged to determine (or detect) voltage spikes from the operational data of the data capture means. In other words, the operational signature comprises an indication of voltage spikes of the motor.

Optionally, at step 208, the controller 102 is arranged to stop providing operational power to the motor 106 (i.e., to power down the motor).

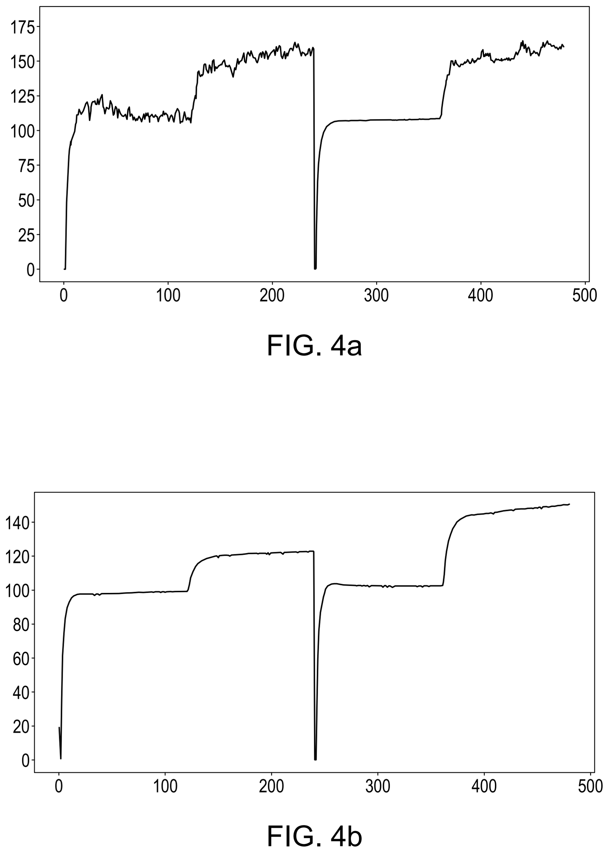

At step 210, as illustrated by Figure 4a, the controller 102 is arranged plot the operational signature of the motor 106 using the frequency and time stamp data determined in steps 203, 204, 205 and 207.

In this embodiment, the operational signature is plotted in the form of a visually readable graph - each data point is plotted as frequency against time (difference). In this regard, the test rig comprises a visual display 114. This display 114 may form part of the test rig 100, or be provided as a separate external component (such as a computer screen) that is arranged to communicate with the test rig 100 to obtain and display the generated operational signature.

As can be seen from Figure 4a, determining and plotting the data in this way accentuates voltage spikes that caused rising edges and were present in the 'raw' sine wave data captured by the tachometer 112. The visually clear 'spikes' in the plotted waveform represent the detected voltage spikes at particular rotational frequency of the motor 106. In the plotted waveform, each detected voltage spike presents as a jump (or spike) in rotational frequency of the motor (because there are more rising edges being detected for a given time period). This indicates to the user that voltage spikes are occurring in the motor, and thus there is a fault (with the motor brush and/or commutator segments of the motor 106). In the example of Figure 4a, the motor 106 is rotated at a first rotational frequency for a first time duration before being rotated at a higher rotational frequency for a second time duration.

Figure 4b illustrates a plotted operational signature of a motor without a fault with the motor brush and/or commutator segments (i.e., a 'working' or 'non-faulty' motor). The rotational duration and frequencies are the same as those for the motor in Figure 4a. However, in this case, there are no observable spikes (or they are drastically reduced relative to those of Figure 4a). This indicates that no (or few) voltage spikes are occurring, and the motor is thus in good working order (or within an acceptable tolerance).

The accentuation of the voltage spikes is a visual indication to the user that there is a fault with the motor 106 (more specifically, the motor brush and/or commutator segments of the motor 106). This visual indication is advantageous because it provides a simpler method of determining whether a motor has a fault. The method removes the need for a user to have specialised training (which is time consuming and expensive) for interpreting the raw data of a tachometer.

In some embodiments, the method may optionally further comprise several additional steps for determining whether the motor is faulty (based on the voltage spikes/detected rising edges). This may further assist the user with their visual assessment of the plotted operational signature generated at step 210.

Optionally, at step 212, the controller 102 is arranged to determine a total number of voltage spikes from the operational signature data. If the total number of voltage spikes is above a pre-determined threshold, the controller is arranged to generate a 'Fail' condition/flag/notification and provide this to the user (e.g., via visual display 114). Otherwise, the controller is arranged to generate a 'Pass' notification and provide this to the user. In other embodiments, the controller may stop determining the number of voltage spikes once the pre-determined threshold number is met (i.e., so that not all voltage spikes have to be determined).

In this document, 'Pass' and 'Fail' notifications mean human readable notifications. In other words, human readable medium/data that indicates to the user whether or not the motor is faulty or not faulty. Thus, instead of a 'Pass' or 'Fail', these notifications might be a 'Green' or 'Red icon, or a 'Tick' or 'Cross' icon etc.

Optionally, the method then proceeds to step 216. In this step, several data points from the set of data points determined at steps 203, 204, 205 and 207 (and/or from the plotted graph generated at step 210) are compared with a set of pre-determined data points (that may be stored in the controller) that represent a 'non-faulty' or good working motor. If the comparison of the data points (or a pre-determined number of data points) from the operational signature data are above a pre-determined tolerance threshold (i.e., of a 'working' motor) when compared to the data points of the 'non-faulty' motor, the controller is arranged to generate a 'Fail' notification and provide this to the user. If the comparisons are within the tolerance threshold, the controller is arranged to generate a 'Pass' notification and provide this to the user.

These additional optional steps therefore provide an indication of a fault with the motor without the user observing the visual indication of the operational signature generated at step 210. In other words, the controller 102 is arranged to determine a fault with the motor from the operational signature of the motor (i.e., without plotting a graph visually to the user).

In some embodiments, in addition to or instead of step 216, the set of pre-determined data points (that may be stored in the controller) that represent a 'non-faulty' or good working motor are plotted in the same way as step 210 (i.e., frequency vs time difference), and the operational signature data is plotted as an overlay to this. This allows the user to easily, visually compare the good working model with the faulty one. This further facilitates determining/identifying a fault with the tested motor.

Each step 212, 216 is optional. Some embodiments will have one of these extra steps and some both of these steps. It is most preferrable to have both of these steps because two different determinations can be made of the motor being faulty, increasing the probability that a faulty motor is detected.

In some embodiments having at least one of steps 212, 216, the controller 102 may not provide the visual indication (generated at step 210) of the operational signature (determined by steps 203, 204, 205 and 207) to the user on the visual display 114. Instead, one of (or both of) steps 212, 216 occurs after step 207 using the data determined from steps 203 to 207, which then provides the user with an indication of fault of the motor 106 (via the 'Pass' or 'Fail' condition/notifications).

In some embodiments, instead of determining rising edges (i.e., at steps 203-207), falling edges are determined. In other embodiments, both rising edge and falling edges are determined.

The method/process of the test rig 100 for detecting a fault with a bearing of the motor will now be described.

As described above, in this embodiment, the test rig 100 also comprises a thermistor 110. The thermistor 110 is connected in series between the PSU 108 and the driver unit 110. In this way, the resistance of the thermistor changes in line with temperature variations of the thermistor 110, which is caused by variations in the current drawn by the motor 106. The thermistor is thus a temperature dependent resistor that is arranged to vary the operational current of the motor.

Again, in this embodiment, the test rig 100 also comprises the user interface 116 for allowing the user to control switching the motor 106 on and off and/or determine what speeds and directions to rotate the motor.

If the motor 106 has worn or seizing bearing issues, the motor 106 will continually speed up and slow down. This is because of additional bearing friction caused by the worn or seizing bearing. The additional friction causes an increase in running current of the motor 106 that increases the temperature of the thermistor. This increases the thermistor resistance, causing a reduction in running current of the motor, which in turn causes the motor to slow down. The reduction in speed of the motor, and reduced current, causes the thermistor to then cool down, decreasing its resistance, therefore allowing increased running current of the motor 106, thus increasing the speed of the motor. This cycle continually occurs (i.e., reduced motor speed, followed by increased motor speed, followed by reduced motor speed, and so on).

As explained above, the tachometer 112 is arranged to produce electrical pulses at a frequency proportional to the rotation speed of the motor 106. The controller 102 is arranged to receive output data from the tachometer 112 that indicates the rotational speed of the motor 106.

In this embodiment, the output data is a 'raw' sine wave obtained from the tachometer 112 (i.e., a plurality of data points having time and voltage amplitude components that (if graphically plotted) represent the 'raw' sine wave, which represents the rotation speed of the motor 106).

The continually increasing and decreasing speed of the motor 106 (caused by the thermistor in response to a bearing fault) is thus detected by the tachometer 112 and present in the 'raw' sine wave (output data) obtained from the tachometer 112. As will be explained, the continually increasing and decreasing characteristic of the motor can be detected and/or plotted on a graph. When plotted, this characteristic is represented as 'ripples' embedded with the detected/output sine wave.

In this embodiment, the operational signature comprises an indication that there is a fault with the bearings of the motor 106. This indication is based on the detected ripples that were generated by thermistor (and in turn by the motor 106) due to the increased friction of the bearings.

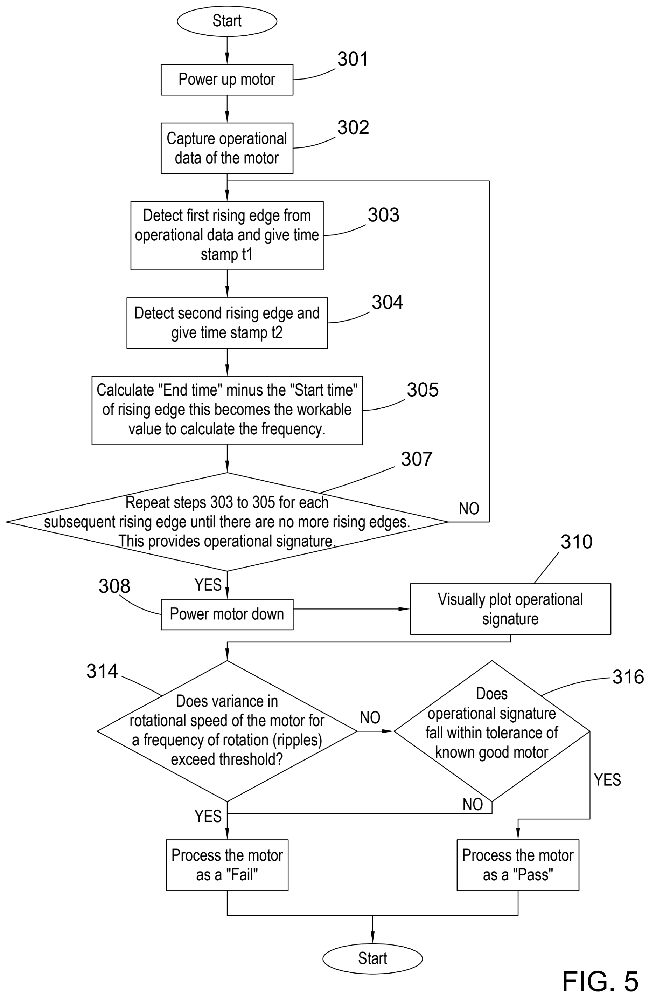

More specifically, in this embodiment, the method is configured to generate a visual representation of the output data that accentuates ripples detected by the tachometer 112. These accentuations are a visual indication to a user there is a fault with the bearings of the motor 106. The steps of this method will now be described in connection with Figure 5.

At step 301, the PSU 108 of the test rig 100 is arranged to supply the motor 106 (via driver board 104) with an operational voltage of between 6 and 59 volts, causing the motor 106 to rotate. In this embodiment, the controller 102 is arranged to cause the motor 106 to rotate at a pre-determined speed in a direction of rotation (i.e., clockwise and anti-clockwise) for a pre-determined time period. In other embodiments, the motor may be arranged to rotate at different speeds and directions of rotation for pre-determined time periods. In this way, motors with differing operational characteristics can be accommodated.

The motor thus draws optimum current from the power supply for its operation. As explained above, if the bearing is faulty, the increased friction will cause the temperature of the thermistor to increase (i.e., the thermistor does not reach a steady state temperature). This causes the resistance of the thermistor to increase, which in turn reduces the current flow, reducing the speed of the motor. The reduced current flow causes the temperature of the thermistor to decrease, therefore decreasing its resistance. This then causes increased current flow, which in turn causes the motor to speed up. The cycle continually occurs.

At step 302, the tachometer 112 (i.e., data capture means) is arranged to produce electrical pulses at a frequency proportional to the rotation speed of the motor 106. In other words, the tachometer 112 is arranged to capture operational data of the motor 106. This output data is provided to (or received by) the controller 102 of the test rig 100.

As described above, the output data comprises a plurality of data points having time and voltage amplitude components. At step 303, the controller 102 is arranged to determine a first rising edge from the operational data (i.e., captured sine wave data) at time t1.

At step 304, a second rising edge of the sine waveform is determined at time t2. At step 305, a frequency of the sine wave is determined from the time between the first and second rising edge (i.e., a difference between t1 and t2). The result of this is then stored (i.e., in a memory of the controller 102).

At step 307, steps 303, 304 and 305 are repeated for all subsequent rising edges of the sine wave (and the results stored). So, a frequency of the sine wave is determined from the time between the second and third rising edge (i.e., a difference between t2 and t3), then for the time between the third rising and edge and the fourth rising edge, and so on. This occurs until the last rising edge of the sine wave has been determined/calculated/processed. The final stored data set represents an operational signature of the motor 106.

Thus, the controller 102 is arranged to determine (or detect) a variance in rotational speed of the motor for a particular frequency of rotation (or 'ripples') caused by a bearing fault from the operational data of the data capture means. In other words, the operational signature comprises an indication of variance in rotational speed of the motor for a particular frequency of rotation.

Optionally, at step 308, the controller 102 is arranged to stop providing operational power to the motor 106 (i.e., to power down the motor).

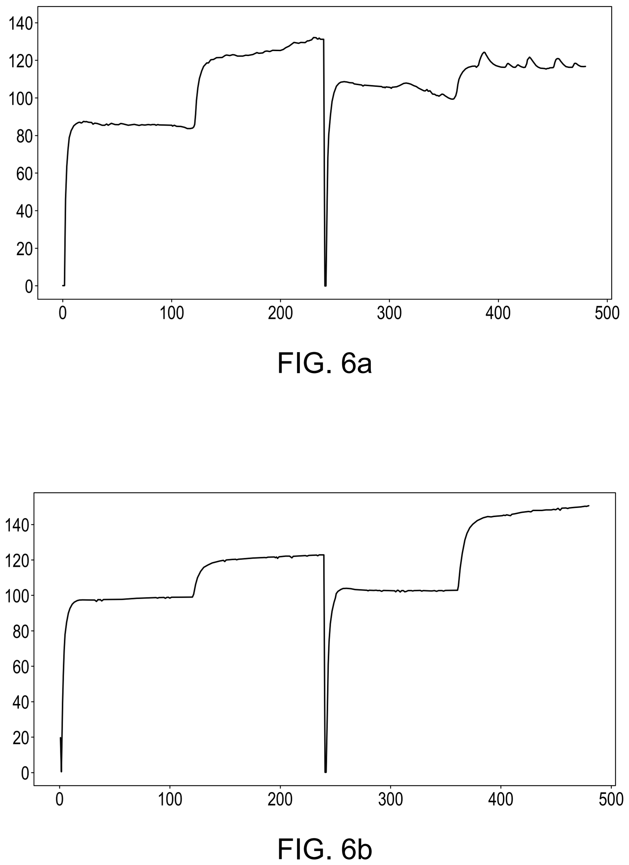

At step 310, as illustrated by Figure 6a, the controller 102 is arranged to plot the operational signature of the motor 106 using the frequency and time stamp data determined in steps 303, 304, 305 and 307.

In this embodiment, the operational signature is plotted in the form of a visually readable graph - each data point is plotted as frequency against time (difference). As above, the plotted operational signature is displayed via display 114.

As can be seen from Figure 6a, determining and plotting the data in this way, accentuates/pronounces the ripples that were present in the 'raw' sine wave data captured by the tachometer 112. These ripples are relatively small variations in rotational speed about a particular desired rotational frequency of the motor 106. Although the speed variations are not as large as those created by the voltage spikes described above, they still vary sufficiently to produce the visually discernible 'ripple' (due to the increased/decreased number of rising edges being created, and then detected etc). In the example of Figure 6a, the motor 106 is rotated at a first rotational frequency for a first time duration before being rotated at a higher rotational frequency for a second time duration.

Figure 6b illustrates a plotted operational signature of a motor without a fault with the bearings (i.e., a 'working' or 'non-faulty' motor). The rotational duration and frequencies are the same as those for the motor in Figure 6a. However, in this case, there is no observable ripple (or it is drastically reduced relative to those of Figure 6a). This indicates that the thermistor has reached a steady state, and in turn the motor has reached a steady rotational speed. The motor is thus in good working order (or within an acceptable tolerance).

The plotting and accentuation of the ripples is a visual indication to the user that there is a fault with the motor 106 (more specifically, the bearings of the motor 106). This visual indication is advantageous because it provides a simpler method of determining whether a motor has a fault. The method removes the need for a user to have specialised training (which is time consuming and expensive) for interpreting the raw data of a tachometer.

In some embodiments, the method may optionally further comprise several additional steps for determining whether the motor is faulty (based on the ripples/detected rising edges). This may further assist the user with their visual assessment of the plotted operational signature generated at step 310.

Optionally, at step 314, the controller 102 is arranged to determine whether ripples are present in the determined operational signature data. This may be achieved, for example, by determining a difference between data point(s) having the highest frequency value and data point(s) having the lowest frequency value. If this difference is above a pre-determined threshold, this indicates the motor is speeding up and slowing down. In this case, the controller is then arranged to generate a 'Fail' condition/flag/notification and provide this to the user (e.g., via visual display 114). Otherwise, the controller is arranged to generate a 'Pass' notification and provide this to the user. In other embodiments, the controller may stop determining the number of 'ripples' once a pre-determined threshold number is met (i.e., so that not all ripples have to be determined).

Optionally, the method proceeds to step 316. In this step, several data points from the set of data points determined at steps 303, 304, 305 and 307 (and/or from the plotted graph generated at step 310) are compared with a set of pre-determined data points (that may be stored in the controller) that represent a 'non-faulty' or good working motor. If the comparison of the data points (or a pre-determined number of data points) from the operational signature data are above a pre-determined tolerance threshold (i.e., of a 'working' motor) when compared to the data points of the 'non-faulty' motor, the controller is arranged to generate a 'Fail' notification and provide this to the user. If the comparisons are within the tolerance threshold, the controller is arranged to generate a 'Pass' notification is and provide this to the user.

These additional optional steps therefore provide an indication of a fault with the motor without the user observing the visual indication of the operational signature plotted at step 310. In other words, the controller 102 is arranged to determine a fault with the motor from the operational signature of the motor (i.e., without plotting a graph visually to the user).

In some embodiments, in addition to or instead of step 316, the set of pre-determined data points (that may be stored in the controller) that represent a 'non-faulty' or good working motor are plotted in the same way as step 310 (i.e., frequency vs time difference), and the operational signature data is plotted as an overlay to this. This allows the user to easily, visually compare the good working model with the faulty one. This further facilitates determining/identifying a fault with the tested motor.

Each step 314, 316 is optional. Some embodiments will have one of these extra steps and some both of these steps. It is most preferrable to have both of these steps because two different determinations can be made of the motor being faulty, increasing the probability that a faulty motor is detected.

In some embodiments having at least one of steps 314, 316, the controller 102 may not provide the visual indication (plotted at step 310) of the operational signature (determined by steps 303, 304, 305 and 307) to the user on the visual display 114. Instead, one of (or both of) steps 314, 316 occurs after step 307 using the data determined from steps 303 to 307, which then provides the user with an indication of fault of the motor 106 (via the 'Pass' or 'Fail' condition/notifications).

In some embodiments, instead of determining rising edges (i.e., at steps 303-307), falling edges are determined. In other embodiments, both rising edge and falling edges are determined.

Each of the set of steps in Figure 2 and Figure 5, the controller is arranged to cause a data capture means (i.e., tachometer) to capture operational data of the motor and determine an operational signature of the electric motor from the operational data. The operational signature comprises an indication of a fault in the motor. For the steps of Figure 2, this indication is via the detected voltage spikes in the wave form. For the steps of Figure 5, this indication is via the detected ripple in the wave form.

In one embodiment, the test rig 100 is arranged to detect both voltage spikes and ripples as indications of a fault with the motor. In these embodiments, the optional steps that may occur for both the voltage spike detection (i.e., steps 212 and 216) and the ripple detection (i.e., steps 314 and 316) include both determining the number of voltage spikes (step 212) and determining the number of ripples (step 314). This increases the likelihood a faulty motor is detected. In this embodiment, if the operational signature is plotted, the plot will accentuate both voltage spikes and ripples in the plotted waveform, thus indicating both faults with the motor.

However, in other embodiments, the test rig 100 may be arranged to detect only one of these (i.e., voltage spikes or ripples). In embodiments whereby the test rig 100 is arranged only to detect/determine voltage spikes, the test rig 100 does not comprise the thermistor 110 (and thus does not cause accentuation and subsequent detection of the ripples). Alternatively, the detected ripples may be discounted/ignored such that only voltage spikes are considered (for visual indications, only voltage spikes are displayed/plotted on the graph). In other words, discrete data points falling within a particular threshold (which corresponds to ripple values) are discounted/ignored. In embodiments whereby the test rig 100 is arranged only to detect/determine ripples, detected voltage spikes may be discounted/ignored such that only ripples are considered (for visual indications, only ripples are displayed/plotted on the graph). In other words, discrete data points above a particular threshold (which corresponds to voltage spike values) are discounted/ignored. In other embodiments, other similar methods to ignore detected ripples and voltage spikes accordingly may be employed (such as using additional hardware, such as capacitors etc, or alternative control methods with analogous function to ignore detections).

In some embodiments (having a visual display 114), the controller can be arranged to continually provide the plotted operational signature of the motor (i.e., from step 210/310) determined from the operational data to the user (via the visual display 114). In this way, the user can view the operational signature of the motor 'in real time'. From this 'live feed', the user may readily determine the motor is faulty, and terminate testing of the motor. This is advantageous because it may omit the need for further processing (such as by steps 212, 216, 314, 316 etc) to determine if the motor is faulty. In this case, the controller 102 is arranged to continually operate the motor and receive operational data from the tachometer (rather than doing so for a pre-determined time period, such as in the steps of Figures 2 and 5).

In this document, 'data capture means' can also mean the controller 102 (rather than the tachometer). The controller captures/obtains operational data from the tachometer (which captures this directly from the motor).

Preferably, the test rig 100 is arranged to be directly coupled to a universal motor for detecting a fault in the motor (i.e., the motor is first removed/isolated from its electrical appliance). In other cases, the test rig 100 is arranged to be indirectly coupled to the motor (i.e., the motor is still connected to its electrical appliance). For the latter case, the motor is tested when running the electrical appliance.

The method of the present invention allows the detection of a mechanical fault in an electric motor of an electrical appliance. Preferably, the motor of the electrical appliance is removed from the appliance, and then coupled directly to the test rig 100. The test rig 100 is arranged to supply the electric motor with an operational voltage that is less than a mains voltage. This provides a safer testing environment using lower operating voltages, reduced current and torque of the motor (relative to testing the motor in the electrical appliance, which is typically supplied with main operational voltage).

## Claims

1. A test rig for detecting a fault in an electric motor comprising:
a power supply means for supplying electrical power to the electric motor; and
a processing means configured to:
cause the power supply means to supply the electric motor with an operational voltage;
operate the electric motor;
receive operational data of the electric motor that is captured by a data capture means;
determine an operational signature of the electric motor from the operational data, wherein the operational signature comprises an indication of a fault with the electric motor; and
provide an indication of the fault to a user based on the determined operational signature,
wherein the data capture means is a tachometer of the electric motor.

2. A test rig according to claim 1, wherein the operational voltage is less than a mains voltage; and/or
wherein the operational data corresponds to a rotational speed of a rotor of the electric motor; and/or
wherein the indication of a fault in the electric motor is a visual indication to the user.

3. A test rig according to claim 2, wherein the visual indication comprises a visual plot of the operational signature of the electric motor.

4. A test rig according to claim 2 or 3, wherein the visual indication comprises a human readable notification; and/or
wherein the indicated fault is a fault with a motor brush and/or commutator segments of the electric motor.

5. A test rig according to claim 4, wherein the operational signature comprises an indication of voltage spikes of the motor thereby indicating a fault with a motor brush and/or commutator segments of the electric motor.

6. A test rig according to claim 5 when dependent upon claim 2, wherein the visual plot of the operational signature visually accentuates the voltage spikes thereby visually indicating a fault to the user; and/or
further comprising a temperature dependent resistor that is coupled to the power supply means, and the indicated fault is a fault with a bearing of the electric motor.

7. A test rig according to claim 6, wherein the temperature dependent resistor is a thermistor.

8. A test rig according to claim 6 or 7, wherein the operational signature comprises an indication of variance in rotational speed of the motor for a particular frequency of rotation thereby indicating a fault with a bearing of the electric motor.

9. A test rig according to claim 8 when dependent upon claim 2, wherein the visual plot of the operational signature visually accentuates the variance in rotational speed of the motor for a particular frequency of rotation thereby visually indicating a fault.

10. A test rig according to any preceding claim, wherein the operational voltage is between 6 and 59 volts; and/or
wherein the test rig is arranged to detect a fault in the electric motor.

11. A test rig as claimed in claim 10, wherein the electric motor has been isolated from an electrical appliance.

12. A method of detecting a fault in an electric motor, the method comprising the steps of:
supplying the electric motor with an operational voltage from a power supply means;
operating the electric motor;
receiving operational data of the electric motor that is captured by a data capture means;
determining an operational signature of the electric motor from the operational data, wherein the operational signature comprises an indication of a fault with the electric motor; and
providing an indication of the fault to a user based on the determined operational signature,
wherein the data capture means is a tachometer of the electric motor.

13. A method as claimed in claim 12, wherein the electric motor is first disconnected from an electrical appliance; and
the operational voltage is less than a mains voltage; and/or
wherein determining the operational signature comprises determining at least one of: the rising edges and the falling edges of the wave form represented by the operational data of the electric motor.

14. A method as claimed in claim 12 or 13, wherein providing an indication of the fault to a user based on the determined operational signature comprises:
comparing a portion of data points of the determined operational signature with corresponding data points of a known operational signature of the electric motor and, if a difference between those data points is above a pre-determined threshold, notifying the user of a fault with the electric motor, otherwise, notifying the user of no fault with the electric motor.

15. A method as claimed in any of claims 12 to 14, wherein the operational signature comprises an indication of voltage spikes of the motor thereby indicating a fault with a motor brush and/or commutator segments of the electric motor; and
providing an indication of the fault to a user based on the determined operational signature further comprises:
determining a number of voltage spikes from the operational signature and, if the number is above a pre-defined threshold, notifying the user of a fault with the electric motor, otherwise, notifying the user of no fault with the electric motor; or
wherein the operational signature comprises an indication of variance in rotational speed of the motor for a particular frequency of rotation thereby indicating a fault with a bearing of the electric motor; and
providing an indication of the fault to a user based on the determined operational signature further comprises:
determining a degree of variance in rotational speed of the motor for a particular frequency of rotation from the operational signature and, if the degree is above a pre-defined threshold, notifying the user of a fault with the electric motor, otherwise, notifying the user of no fault with the electric motor.
